# EUROPEAN PATENT APPLICATION

(11) **EP 2 853 912 A1**
(43) Date of publication of application: **01.04.2015**
(21) Application number: 14186466.0
(22) Date of filing: 25.09.2014
(51) Int. Cl.: G01R 35/00, G01R 31/319, G01R 1/067

(54) **Time-domain reflectometer de-embed probe**

(30) Priority: 25.09.2013 US 201361882298 P; 27.06.2014 US 201414317389
(71) Applicant: Tektronix, Inc., Beaverton, Oregon 97077-0001 (US)
(72) Inventor: Knierim, Daniel, Beaverton, OR 97008 (US); Hickman, Barton, Portland, OR 97229 (US)
(74) Representative: Clarke, Jeffrey David

(57) **Abstract**

A de-embed probe (100) including an input (114, 116) configured to connect to a device under test, a memory (108), a signal generator (102) connected to the input, the signal generator configured to generate a test signal, and a controller (110) connected to the signal generator and configured to control the signal generator. The de-embed probe may be used in a test and measurement system. The test and measurement system also includes a test and measurement instrument including a processor connected to the controller of the de-embed probe, the processor configured to provide instructions (120) to the controller, and a test and measurement input to receive an output (118) from the de-embed probe.

## Description

### TECHNICAL FIELD

The disclosed technology relates generally to signal acquisition systems, and more particularly, to a de-embed probe with an internal signal generator for reducing measurement errors due to the probe tip loading of a device under test.

### BACKGROUND

De-embed probes as described in U.S. Patent No. 7,460,983 titled SIGNAL ANALYSIS SYSTEM AND CALIBRATION METHOD, U.S. Patent No. 7,414,411 titled SIGNAL ANALYSIS SYSTEM AND CALIBRATION METHOD FOR MULTIPLE SIGNAL PROBES, U.S. Patent No. 7,408,363 titled SIGNAL ANALYSIS SYSTEM AND CALIBRATION METHOD FOR PROCESSING ACQUIRES SIGNAL SAMPLES WITH AN ARBITRARY LOAD, and U.S. Patent No. 7,405,575 titled SIGNAL ANALYSIS SYSTEM AND CALIBRATION METHOD FOR MEASURING THE IMPEDANCE OF A DEVICE UNDER TEST, each of which is incorporated herein by reference in its entirety, use switched loads inside the probes across the probe tips to take measurements. The S-parameters of the de-embed probe are measured at manufacturing time and stored in an S-parameter memory inside the probes. A user then connects a probe to the device under test and presses a calibration button. The scope takes two or three averaged acquisitions each with a different de-embed load switched across the probe tip.

After the acquisitions, the oscilloscope can compute the impedance of the device under test as a function of frequency and also provide a fully de-embedded view of the waveform at the device under test as if the probe and oscilloscope had never been connected. This can also be done by incorporating the above discussed method into a vector network analyzer using two de-embed probe fixtures with a signal source and a setup to operate as a vector network analyzer using two de-embed probes, as discussed in U.S. Patent Application No. 14/267,697, titled TWO PORT VECTOR NETWORK ANALYZER USING DE-EMBED PROBES, which is hereby incorporated by reference in its entirety.

Source impedance, as a function of frequency, of a probed time domain signal may be determined by a de-embed probe with a variety of load components, such as the de-embed probe described in U.S. Application No. 14/261,834, titled SWITCHED LOAD TIME-DOMAIN REFLECTOMETER DE-EMBED PROBE, hereby incorporated by reference in its entirety. The source impedance is determined by observing the signal of a device under test under the known load conditions within the de-embed probe.

U.S. Patent Application No. 14/267,697, titled TWO PORT SYSTEM NETWORK ANALYSIS USING DE-EMBED PROBES, discusses how to determine the S-parameters from a device under test with an external signal generator and two de-embed probes.

However, all these switched-load de-embed methods require a test signal from the device under test (DUT) or an external signal generator to excite the system across all frequencies of interest in a repeatable manner. In some situations, the DUT signal may not have suitable frequency content or be repeatable, or the user may wish to measure the DUT impedance in a quiescent state.

### SUMMARY

What is needed is a de-embed probe with an internal signal generator without any switched-load components required. Certain embodiments of the disclosed technology include a de-embed probe including two inputs configured to connect to a device under test, a memory, a signal generator connected to the two inputs, the signal generator configured to generate a test signal, and a controller connected to the signal generator and configured to control the signal generator.

Certain embodiments of the disclosed technology also include using the de-embed probe described above within a test and measurement system. The test and measurement system also includes a test and measurement instrument including a processor connected to the controller of the de-embed probe, the processor configured to provide instructions to the controller, and a test and measurement input to receive an output from the de-embed probe.

Certain other embodiments of the disclosed technology include a method for performing a voltage measurement of a test signal within an active device under test. The method includes injecting a test signal into a node of the device under test, and separating a first voltage measurement related to a signal of the device under test from a second voltage measurement related to the test signal.

### BRIEF DESCRIPTION OF THE DRAWINGS

FIG. 1 illustrates a block diagram of a de-embed probe of the disclosed technology.
FIG. 2 illustrates a test and measurement system using the de-embed probe of FIG. 1.
FIGS. 3-5 illustrate block diagrams of de-embed probes according to other embodiments of the disclosed technology.

### DETAILED DESCRIPTION

In the drawings, which are not necessarily to scale, like or corresponding elements of the disclosed systems and methods are denoted by the same reference numerals.

The disclosed technology includes a de-embed probe 100 with a signal generator 102 located within the probe. Unlike U.S. Application No. 14/261,834, titled SWITCHED LOAD TIME-DOMAIN REFLECTOMETER DE-EMBED PROBE, the de-embed probe only contains a signal generator and does not contain any switched loads. The de-embed probe 100 can be a standard probe with standard probe tips. The de-embed probe 100 can also be implemented as a plug-in module. The de-embed probe may be used with any number of input connections, such as, but not limited to, a solder-in probe tip.

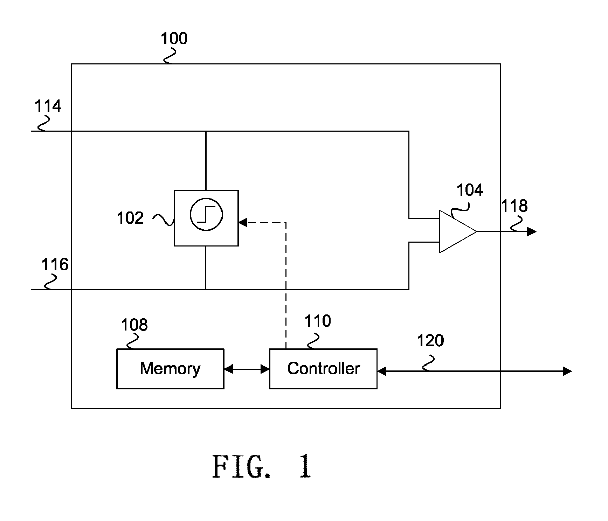

The de-embed probe 100 includes an amplifier 104 connected to the output 118, along with the typical circuitry found in de-embed probes and as discussed in the above mentioned patent application. The typical circuitry is not shown in FIG. 1.

The de-embed probe 100 also includes a memory component 108. The memory component 108 stores the measured S-parameters of the probe 100 to be shared with a test and measurement instrument so that a de-embedded view of the waveform can be provided. The memory component 108 may also store typical functions that probes already incorporate. Further, the memory component 108 is not limited to a single component. The memory component 108 may be made up of multiple memory components.

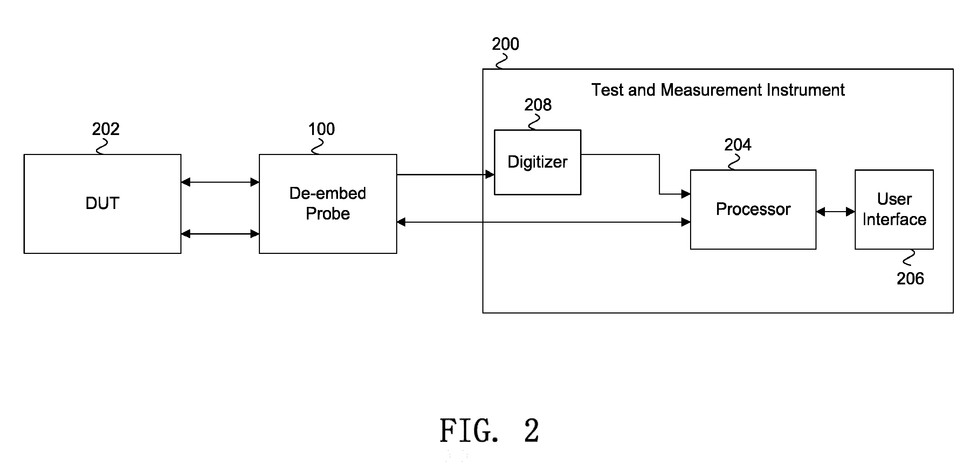

As mentioned above, the de-embed probe 100 also includes a signal generator 102. The signal generator 102 is controlled by a controller 110 that is in communication with a processor 204 of a test and measurement instrument 200 as shown in FIG. 2. The signal generator 102 may be a step generator as traditionally used for TDR, an impulse generator, a swept sine generator, or another source of broad-band frequency content. The signal generator 102 is preferably integrated with amplifier 104 so as to maintain a small size of the de-embed probe.

De-embed probe 100 can be used to probe both active and quiescent nodes of a device under test 202 to provide the necessary measurements. It is desirable to be able to measure the source impedance of a device under test 202 when the node is active because it is often inconvenient, or even impossible, to switch the device under test 202 from a quiescent to active operation when switching from an impedance measurement to a de-embed voltage measurement mode. Further, the source impedance may change between a quiescent and active operation.

To be able to accomplish the measurements on an active node of a device under test 202, the processor 204 of the test and measurement instrument 200, as shown in FIG. 2, is able to separate the voltage signal at the de-embed 100 probe inputs 114 and 116, or tip, due to the injected current from the signal of the device under test 202.

As seen in Fig. 2, the test and measurement instrument 200 also includes a digitizer 208. The output from the probe 100 is generally an analog signal. This analog signal is digitized by digitizer 208 so that processor 204 can act upon the signal.

In some embodiments of the disclosed technology, one technique used to distinguish the injected test signal from the signal generator 102 versus the signal from the device under test 202 is to inject the test signal at times that are random compared to the signal from the device under test 202. The test and measurement instrument 200 can be triggered on the injected signal from the signal generator 102. Those acquisitions can then be averaged. Averaging the acquisitions will cause the average of the signal from the device under test 202 to average toward zero. Accordingly, the voltage measurement from only the injected test signal from the signal generator 102 can be determined by averaging out the voltage measurement of the signal from the device under test 202.

In other embodiments of the disclosed technology, the injected test signal from the signal generator 102 can be separated from the signal from the device under test 202 by injecting the test signal from the signal generator 102 at times fixed with respect to a trigger point of a repetitive signal from a device under test 202. Then, acquisitions can be taken with the test signal present and with the test signal not present. The signal generator 102 is controlled by controller 110. Controller 110 receives instructions from processor 204 in the test and measurement instrument 200 through communication link 120. The acquisitions can then be subtracted from each other to separate the voltage measurement at the probe tip due to the injected signal from the signal generator 102 and the voltage measurement from the signal of the device under test 202. However, some averaging may still be required to reduce random noise located within the acquisitions.

The controller 110 can also control whether the test signal from the signal generator 102 is inputted to the input 114 or the input 116. The signal generator can be inputted to both depending on the desired acquisitions necessary. Different test signals from the signal generator 102 may be sent to input 114 and input 116. For example, input 116 may receive a test signal that is an inverse of a test signal sent to input 114. In some embodiments, multiple signal generators (not shown) may be used to generate the different test signals for inputs 114 and 116. For example, when using multiple signal generators, one signal generator is connected to input 114 and one signal generator is connected to input 116. Each signal generator sends a test signal to each input.

Further, to avoid interfering with the normal operation of the device under test 202, when measuring an active node of the device under test 202, the injected current of the test signal from the signal generator 102 must be small compared to the current of the signal in the node of the device under test 202. The injected current, however, also cannot be too small. If the injected current of the test signal is too small compared to the signal current of the device under test 202, the accuracy of the impedance measurement is degraded and/or the measurement time may be increased.

The amplitude of the injected signal from the signal generator is programmable so that it can be tailored to the size of the signal from the device under test 202. That is, the injected signal amplitude is a percentage of the signal from the device under test. However, if a quiescent node is probed without a DUT signal, a percentage of the DUT signal cannot be used. In that case, a percentage of the DUT signal that would be present if the node were active may be used. Further, the test and measurement instrument 200 may automatically determine the amplitude of the test signal from the signal generator 102 based on the amplitude of the measured signal of the device under test 202.

That is, a user of the test and measurement instrument may input the desired amplitude of the injected signal into a user interface 206 of the test and measurement instrument 200 or the test and measurement instrument 200 can automatically select the desired amplitude of the injected signal. The user interface 206 communicates with the processor 204, and the desired amplitude is sent from the processor 204 to the controller 110 of the de-embed probe 100 through communication link 120.

Calibration of the de-embed probe 100 still requires measurement of the load impedance of the de-embed probe 100 and storing the measurement in the memory component 108. Further, if the load impedance changes when the injection is turned off, such may also be measured and stored in the memory component 108. The through-response of the de-embed probe 100 also needs to be measured and stored in the memory component 108.

Further, the test signal to be injected into the node of the device under test 202 would also need to be measured and stored. This can be accomplished by acquiring the injected test signal from the signal generator 102 through the de-embed probe 100 with a known load, e.g., open-probe tip floating. The acquired signal, in the frequency domain, will be the product of the injected test signal current, the probe load impedance, and the probe through response.

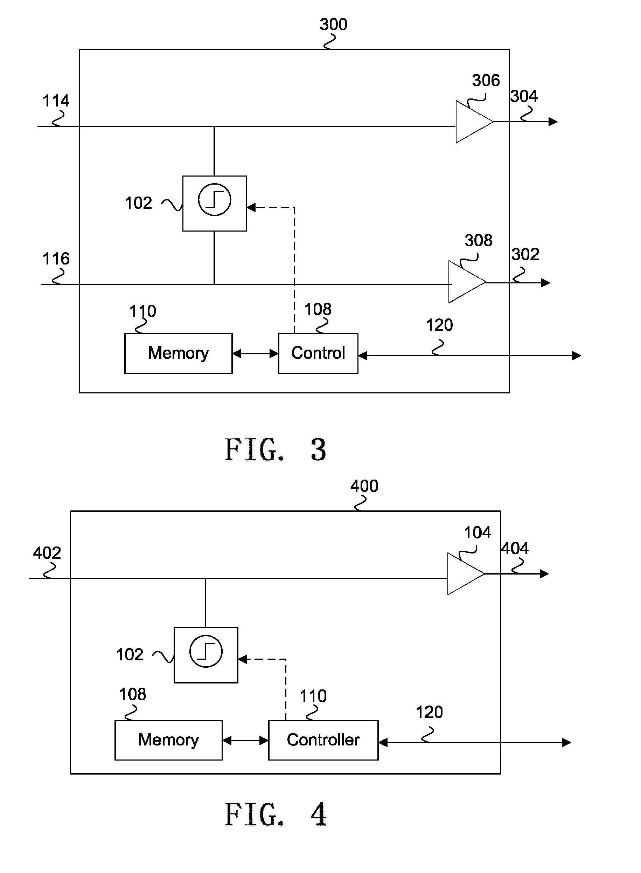

The de-embed probe 100, however, is not limited to a three-port de-embed probe, as shown in FIG. 1. The de-embed probe can also be a four-port de-embed probe 300 as shown in FIG. 3. The four-port de-embed probe 300 is similar to the three-port de-embed probe 100, except two outputs 302 and 304 are provided with amplifiers 306 and 308. Further, de-embed probe may also be a single-ended de-embed probe 400 with a single input 402 and a single output 404, as shown in FIG. 4.

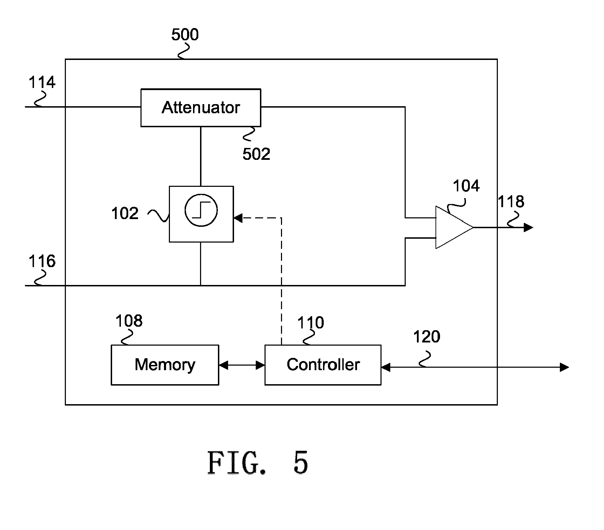

Further, the test signal from the signal generator 102 does not need to be provided directly to the probe inputs 114 and 116. The test signal, for example, may be inputted to an attenuator 502, as seen in FIG. 5, prior to being sent to the input 114 of the de-embed probe 500.

De-embed probes 100, 300, 400 and 500 can be used to acquire a variety of measurements that can be transmitted to the processor 202 of the test and measurement instrument through the output 118. For example, the node source impedance, signal voltage from the device under test 202 if unloaded, voltage signal from the device under test 202 if under some particular load, and a transfer gain from a signal on a present node to another probed node can be determined using the disclosed technology. The acquired test signal, in the frequency domain, when probing the device under test 202 is the product of the injected test signal current, the parallel combination of the device under test 202 and the probe load impedance, and the probe through response. Solving for the device under test 202 impedance allows for the determination of the voltage divider effect of the device under test 202 impedance driving the probe load impedance. Dividing this voltage-divider ratio into the acquired device under test 202 signal provides the unloaded view of the device under test 202 signal. The device under test 202 transfer gain from one node to another is the ratio of the calculated unloaded test signal response of the second node to the loaded (actual) injected voltage on the first node.

Preferably, the de-embed probes 100, 300, 400, and 500, described above, are high impedance de-embed probes, rather than traditional 50Ω probes. That is, the input impedance of the de-embed probes 100, 300, 400, and 500 are substantially higher than a characteristic impedance of a device under test 202. For example, the probe input impedance may be 50KΩ at low frequency, dropping to 225Ω at high frequency, whereas the device under test impedance may be nominally 25Ω in a typical double-terminated 50Ω system.

Processor 204 and a memory (not shown) in the test and measurement instrument 200 store executable instructions for implementing the above discussed features. Computer readable code embodied on a computer readable medium, when executed, causes the computer to perform any of the above-described operations. As used here, a computer is any device that can execute code. Microprocessors, programmable logic devices, multiprocessor systems, digital signal processors, personal computers, or the like are all examples of such a computer. In some embodiments, the computer readable medium can be a tangible computer readable medium that is configured to store the computer readable code in a non-transitory manner.

Having described and illustrated the principles of the disclosed technology in a preferred embodiment thereof, it should be apparent that the disclosed technology can be modified in arrangement and detail without departing from such principles. We claim all modifications and variations coming within the scope of the following claims.

## Claims

1. A de-embed probe, comprising:
an input configured to connect to a device under test;
a memory;
a signal generator connected to the input, the signal generator configured to generate a test signal; and
a controller connected to the signal generator and configured to control the signal generator.

2. The de-embed probe of claim 1, wherein an input impedance of the de-embed probe is higher than a characteristic impedance of the device under test.

3. The de-embed probe of claim 1 or 2, wherein the de-embed probe does not include any switchable load components.

4. The de-embed probe of any preceding claim, the controller further configured to switch the signal generator on and off.

5. The de-embed probe of any preceding claim, the controller further configured to adjust an amplitude of the test signal.

6. The de-embed probe of any preceding claim, where the de-embed probe comprises two inputs configured to connect to a device under test.

7. A test and measurement system, comprising:
the de-embed probe of any of claims 1 to 6; and
a test and measurement instrument including:
a processor connected to the controller of the de-embed probe, the processor configured to provide instructions to the controller, and
a test and measurement input to receive an output from the de-embed probe.

8. The test and measurement system of claim 7, wherein the test and measurement instrument further includes a user interface configured to accept an indication of a desired amplitude of the test signal.

9. The test and measurement system of claim 7 or 8, wherein the processor automatically selects an amplitude of the test signal based on an amplitude of a received signal from a device under test at the test and measurement input, and wherein the controller is further configured to adjust the amplitude of the test signal based on the selection.

10. The test and measurement system of any of claims 7-9, wherein the processor of the test and measurement instrument receives from the test and measurement instrument an output from the device under test and calculates the source impedance of the device under test.

11. The test and measurement system of any of claims 7-10, wherein the processor of the test and measurement instrument receives an output from the device under test and calculates the unloaded signal present on the device under test before the de-embed probe connects to the device under test.

12. A method for performing a voltage measurement of a test signal within an active device under test, comprising:
injecting a test signal into a node of the device under test; and
separating a first voltage measurement related to a signal of the device under test from a second voltage measurement related to the test signal.

13. The method of claim 12, wherein the test signal is injected randomly compared to the signal from the device under test, and
wherein separating the first voltage measurement related to the signal of the device under test from the second voltage measurement related to the test signal includes:
triggering an acquisition each time the test signal is injected, and
averaging the acquisitions to determine the second voltage measurement related to the test signal.

14. The method of claim 12, wherein the test signal is injected at times fixed to the signal from the device under test, and
wherein separating the first voltage measurement related to the signal of the device under test from the second voltage measurement related to the test signal includes:
acquiring an acquisition when the test signal is on,
acquiring an acquisition when the test signal is off, and
subtracting the acquisition when the test signal is off from the acquisition when the test signal is on to determine the second voltage measurement related to the test signal.
